# EUROPEAN PATENT APPLICATION

(11) **EP 3 527 994 A1**
(43) Date of publication of application: **21.08.2019**
(21) Application number: 18157640.6
(22) Date of filing: 20.02.2018
(51) Int. Cl.: G01R 1/04, G01R 31/28

(54) **CONTACTOR SOCKET AND IC TEST APPARATUS**

(71) Applicant: Rasco GmbH, 83059 Kolbermoor (DE)
(72) Inventor: Mitterer, Johannes, 83026 Rosenheim (DE); Meier, Martin, 83135 Schechen (DE); Wagner, Markus, 83059 Kolbermoor (DE)
(74) Representative: Heinze, Ekkehard

(57) **Abstract**

Contactor socket (110) of an IC test handler, the contactor socket comprising a contactor socket body (111) having a first and second plane surface, the second plane surface being parallel and opposite to the first plane surface, and a line or an array of test contacts (112) supported within the contactor socket body, extending between the first and second plane surface and adapted for providing elastic pressure contact with IC device contacts of a plurality of ICs (131) which are positioned on the first plane surface and/or with loadboard contacts of a loadboard positioned on the second plane surface and, thus, an electrical connection between the IC device contacts and loadboard contacts, wherein the contactor socket body has at least one fluid inlet (114) and at least one fluid outlet (115) and at least one fluid channel (113) connecting the fluid outlet with the fluid inlet, each of the test contacts being positioned in the or at least one fluid channel, wherein at least one temperature sensor is arranged in the or at least one fluid channel and the contact socket comprises throttle means (117') arranged at the fluid inlet or fluid outlet or at an inlet side of at least one fluid channel and/or heating and/or cooling means arranged at the or close to the fluid inlet, for heating or cooling a fluid flowing from the fluid inlet through the or the respective fluid channel to the fluid outlet.

## Description

### Field of the Invention

The invention is related to a contactor socket of an IC test handler, which has test contacts for contacting an IC or a group of ICs in test and is adapted for temporarily pressing the IC or ICs against the test contacts. It further relates to an IC test apparatus.

### Background of the Invention

It is well-known to run test procedures on integrated circuits, e.g. in a configuration where the ICs are arranged on an IC strip, to verify the correct function of the ICs. Such test systems allow for a simultaneous testing of a plurality of ICs, which increases the throughput of the testing system and, therefore, the productivity and results in a cost reduction per IC. A dedicated test-in-strip handler places the ICs in contact with a contactor socket of the test system, maintains the contact for the duration of the test cycle, and finally sorts the ICs depending on the test results, before delivering them to a packaging stage or other stages for further processing.

In a test-in-strip handler, a loader unit is provided which contains a stack of IC strips. From this stack, individual IC strips are fed to a testing unit which comprises a plunger or plunger head, for example, that positions the selected IC strip such that the test contacts of the contactor socket come into electrical contact with respective device contacts of the ICs. Thereafter, the above-referenced test procedure is started and implemented. After testing, the IC strip is unloaded to an unloader unit, and the above-mentioned sorting operation is carried out.

A contactor arrangement according to the state of the art is disclosed in EP 2963430 A1 of the applicant.

For a couple of years, it has been known that the thermal conditions during an IC testing procedure can have a significant influence on the test results. Therefore, contactor sockets have been developed, which have a fluid inlet, to be connected to a fluid source, and a fluid outlet and at least one fluid channel connecting the fluid outlet with the fluid inlet, and wherein the test contacts are positioned in the fluid channel and, thus, in a fluid flow of a fluid (in particular a gas) which is generated by the fluid source. Such constructions have been proven as effective for bringing and maintaining the temperature of the test contacts of the contactor socket to/at a temperature which is, to a large extent, equal to the temperature of the fluid coming from the fluid source.

### Description of the Invention

It is an object of the invention to provide an improved contactor socket which enables a further improved thermal management of one or more device/s under test (DUT) according to predetermined requirements or test programs, respectively.

This object is solved by a contactor socket comprising the features of claim 1. According to further aspects of the invention, the object is solved by an IC test apparatus of claim 13 or claim 14. Embodiments of the invention are subject of the dependent claims.

It is a basic idea of the invention, to provide an improved contactor socket which is adapted for flexible temperature adjustment or temperature control, respectively, of the test contact temperature, according to the requirements of a specific test case. Furthermore, an IC test apparatus is provided, which allows for such temperature adjustment or temperature control, respectively, on an apparatus level.

It is an aspect of the invention, to provide a contactor socket which includes at least one temperature sensor arranged in the or at least one fluid channel within the contactor socket, in which fluid channel at least one of the test contacts of the socket is positioned. The temperature signal output by such temperature sensor/s serves as a basis for the required temperature adjustment or temperature control, respectively.

It is a second aspect of the invention, that the contactor socket is provided with throttle means arranged at the fluid inlet or fluid outlet or at an inlet side of at least one fluid channel and/or heating and/or cooling means arranged at the or close to the fluid inlet, for heating or cooling a fluid flowing from the fluid inlet through the or the respective fluid channel to the fluid outlet. The term "throttle means" in the present application shall cover all types of technical means which are suitable for restricting a fluid flow from a fluid inlet to a fluid outlet of the contactor socket, including static cover plates or orifice plates, respectively, or any moveable means for changing the effective cross-section of one or more fluid channel/s, including manually actuated or electrically or magnetically controlled elements.

According to an embodiment of the invention, the or at least one temperature sensor is arranged close to a test contact and/or close to the fluid outlet. Although such positioning of the temperature sensor/s might influence the fluid flow around the test contact/s, it is advantageous insofar as the temperature signal provided by the sensor reflects the real temperature of the respective test contact as close as possible.

In a further embodiment, the throttle means comprise a plurality (set) of exchangeable inserts to be arranged on the fluid inlet or in the or at least one fluid channel, each of the inserts having a fluid opening the size of which is different from the fluid openings of each of the other inserts of the set. This embodiment allows for a flexible, though static, adjustment of the fluid flow through one or more fluid channels in response to pre-determined thermal conditions and according to (static) requirements of a specific test application.

In a further embodiment, the throttle means comprise moveable adjustment means for reducing the size of an fluid opening in the fluid inlet or in the or at least one fluid channel. This embodiment allows for a "dynamic" adjustment of the fluid flow and, thus, of the test contact temperature/s without necessitating the cumbersome handling of a set of different inserts to be replaced in the contactor socket body, although on the other hand it requires a more sophisticated construction of the throttle means. Most importantly, this embodiment allows for a dynamic reduction of the fluid flow around the test contacts according to timely changing thermal conditions o requirements of the test case.

In still another embodiment of the invention, the heating or cooling means comprise an electroresistive heating element or Peltier cooling element. Such embodiments are well adapted to the small size of the test contacts and fluid channels of typical contactor sockets, and the respective heating and cooling elements are commercially available on a low-cost basis.

In a further embodiment, the configuration of the contactor socket is such that the fluid inlet is arranged on a first edge and the fluid outlet is arranged on a second edge thereof, opposite to the first edge. Such configuration facilitates achieving a basically laminar fluid flow, to avoid difficult-to-predict temperature peaks or sinks within the fluid channel/s and, thus, facilitates influencing the test contact temperature by means of actuating the throttle means in a predictable and reliable way.

In a further embodiment of the invention, the contactor socket is adapted for a test-in-strip handler, comprising a plurality of groups of test contacts, each group of test contacts to provide an electrical connection between a single IC device (DUT) and the loadboard. Herein, the plurality of test contact groups is arranged in a matrix type arrangement of n rows and m columns. Herein, the contactor socket comprises at least n fluid channels, each of the n rows of the test contact groups being arranged in a row dedicated fluid channel and each of the row dedicated fluid channels comprising at least one temperature sensor. This is a practically important implementation of the inventive contactor socket, and this configuration of the fluid channels with respect to the test contact groups allows for an efficient, though flexible, temperature control in the framework of a relatively simple socket construction.

In a further embodiment, specifically to be implemented in a contactor socket adapted for a test-in-strip handler, at least one temperature sensor is arranged in a central portion of the respective row dedicated fluid channel. Such positioning of a (single) temperature sensor within the fluid channels of that specific contactor socket configuration provides an optimum accuracy and reliability of the temperature signal for each of the test contact groups which are arranged in that fluid channel.

In a further embodiment of the contactor socket dedicated to the test-in-strip handler, the direction of extension of the fluid channels is approximately perpendicular to the direction of extension of the device strip in its test state arranged on the contactor socket. This provides for a relatively simple construction of the contactor socket body, at the same time providing a basic configuration which enables a precise and fast-response temperature control of the test contact groups. For this purpose, and for facilitating a selective temperature control of the several test contact groups, in a further embodiment the number of fluid channels is at least equal to the number of rows of contact element groups.

In an alternative arrangement of the fluid channels with respect to the device strip, the fluid channels extend approximately parallel to the direction of extension of the device strip arranged on the contactor socket.

In a more specific exemplary configuration of the contactor socket dedicated to a test-in-strip handler, the direction of extension of the fluid channels is inclined at an acute angle with respect to the direction of extension of the rows of test contact groups, to an extent such that each row of test contact groups is still arranged within a single row dedicated fluid channel. The angle between the direction of extension of the fluid channel and the row of the test contacts may be between 5° and 45°, more specifically between 10° and 30°, depending on the number m of test contact groups in the row and the geometrical configuration of the contactor socket body.

Each of the neighbored test contact groups sits in a fluid passage, which enables part of a fluid flowing through the row dedicated fluid channel between the neighbored test contact groups. In such exemplary configuration, the fluid flowing from an inlet end to an outlet end of the respective fluid channel is forced to flow around and between all test contacts of the respective test contact groups, to facilitate achieving a homogeneous temperature distribution within and over all test contact groups in the respective fluid channel.

In a more specific implementation of the last mentioned embodiment, between the fluid inlet and the row dedicated fluid channels a plurality of p (p ≥ n) fluid inlet channels and between the row dedicated fluid channels and the fluid outlet a plurality q (q ≥ n) of fluid outlet channels is provided.

In an embodiment of the inventive IC test apparatus, temperature display means are provided for displaying the or each of the fluid channel temperature values provided by the temperature determining unit. These display means indicate the test contact temperature to an operator, and they enable a test operator to "manually" exchange or actuate the throttle means of the contactor socket, for adjusting the temperature of the test contact/s.

In another embodiment of the IC test apparatus, a temperature control unit is provided, for automatically actuating the throttle means in the contactor socket in response to the or each temperature value provided by the temperature determining unit, for controlling the temperature of the test contact/s.

According to a relatively independent aspect of the invention, at least one temperature sensor is provided in at least one fluid channel of the contactor socket, whereas the contactor socket itself does not necessarily contain internal temperature control means. Rather, the signal/s of the temperature sensor/s can be delivered to a temperature control unit - optionally via a separate temperature determining unit - and processed in such temperature control unit for generating a temperature control signal which drives temperature control means arranged outside the contactor socket or which are attached to the contactor socket. Such temperature control unit is, in a preferred embodiment, part of a test handler. The temperature control means external of the contactor socket can be at least one of fluid control means, heating means and cooling means, which can be arranged in a fluid passage between a fluid source and the fluid inlet of the contactor socket.

### Brief Description of the Drawings

Further embodiments and advantages of the invention or of specific elements or aspects thereof are explained in the following description, and related to the appending drawings. In the drawings,
Fig. 1 schematically shows a first embodiment of the inventive IC test apparatus,
Fig. 2 schematically shows a further embodiment of the inventive IC test apparatus,
Fig. 3 shows, in a perspective view, a contactor socket according to an embodiment of the invention, with removed cover plate.

### Description of the Embodiments

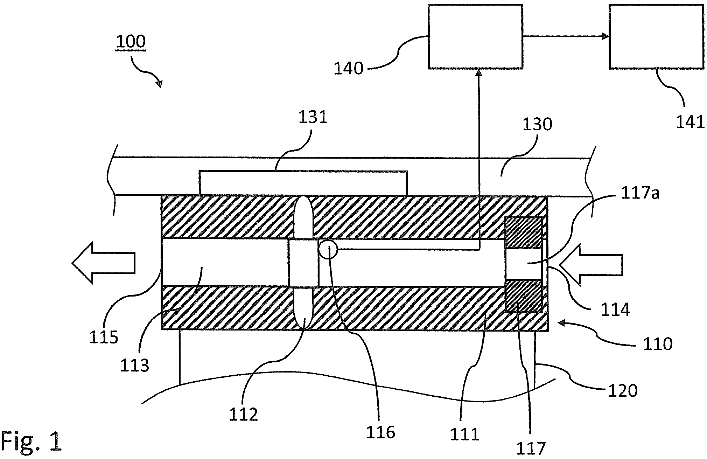

Fig. 1 schematically shows major components of an IC test apparatus 100 in an operational state, wherein a contactor socket 110 is arranged between a loadboard 120 and an IC strip 130 containing ICs 131 under test (DUTs). The contactor socket 110 comprises, in a contactor socket body 111, a plurality of test contacts 112 (only one of which is shown in the figure), a major portion of which is positioned in a fluid channel 113 which extends between a fluid inlet 114 and a fluid outlet 115 of the contactor socket. In close proximity to the test contact 112, a temperature sensor 116 is provided, and close to the fluid inlet 114 throttle means 117 for adjusting a fluid flow through the fluid channel 115 are provided.

In the embodiment shown in Fig. 1, the throttle means 117 are embodied as an exchangeable insert, which has a central reduction orifice 117a for locally reducing the effective cross-section of the fluid channel 115. The insert 117 is part of a set of inserts which have differently sized reduction orifices, to adjust the fluid flow through the contactor socket 110.

The temperature sensor 116 is connected to an input of a temperature determining unit 140 for determining a temperature signal which reflects the actual temperature of the test contact 112, and the output thereof is connected to a temperature display unit 141 for displaying the temperature value to a rest operator. The operator can, depending on the displayed value and predetermined requirements of the test case, remove or replace the insert 117 with another insert of the above-mentioned set.

In a modified first embodiment, the throttle means can be embodied as an integral adjustable throttle within the contactor socket body 111, and throttle actuating means for manually adjusting the effective cross section of the throttle can be provided.

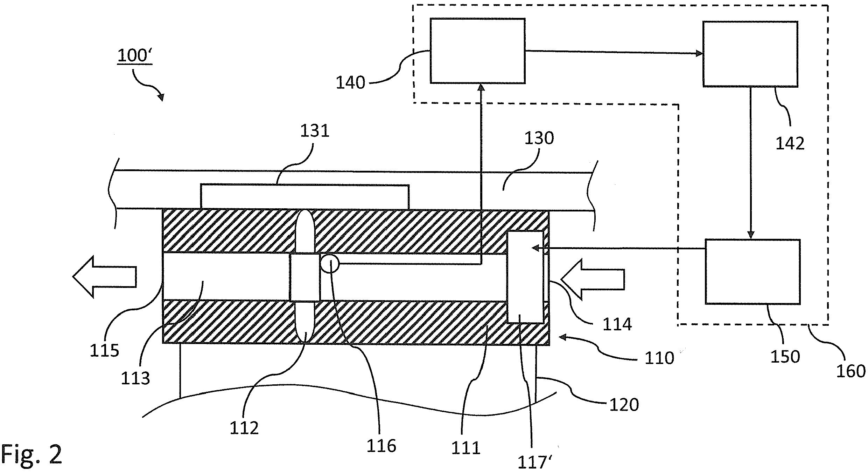

Fig. 2 schematically shows a further embodiment, which is basically likewise a modification of the first embodiment according to Fig. 1. Identical or functionally identical components are designated with the same or similar reference numerals, and the description of such components will not be repeated here.

The test apparatus 100' of Fig. 2 differs from the test apparatus 100 in Fig. 1 mainly in the way how the temperature signal output by the temperature determining unit 140 is being used, and in the nature of the throttle means 117'. The throttle means 117' (shown as a functional block) is connected to a throttle actuating unit 150, and an input of the throttle actuating unit 150 is connected to the output of a temperature control unit 142. The temperature control unit 142 receives the temperature signal from the output of the temperature determining unit 140 and generates, based on pre-stored processing criteria and parameters, a control signal which is output to the throttle actuating unit. The throttle actuating unit 150 can comprise an electrical, e.g. piezoelectric, or electromagnetic actuator for adjusting the effective cross-section of the throttle 117'. In the Figure, as an optional but preferred aspect it is indicated with a broken line, that the temperature determining unit 140, temperature control unit 142, and throttle actuating unit 150 are components of a test handler 160 of the test apparatus 100.

The basic configuration which is schematically shown in Fig. 2 can be modified by replacing the throttle means with other technical means to control the temperature of the test contacts, in particular with a heating or cooling element, respectively, which sits in an inlet portion of the fluid channel, relative to the test contact. Such heating or cooling elements are known as such, and they can easily be driven directly by the temperature control unit. The implementation of such modified embodiments is within the capabilities of one of ordinary skill in the art and need not be described in more detail here.

Whereas in Figures 1 and 2 exemplary only a single test contact, a single fluid channel and a single throttle are shown, it shall be understood that the contactor socket can - and in the most important embodiments thereof will - comprise a plurality of test contacts or test contact groups, respectively, and plural fluid channels and that plural throttles can be provided at least in part of the plural fluid channels. Although in the figures it is shown that the throttle is positioned at the inlet side of the contactor socket, it can also be arranged at the outlet side thereof or even be attached to the respective end face of the contactor socket body.

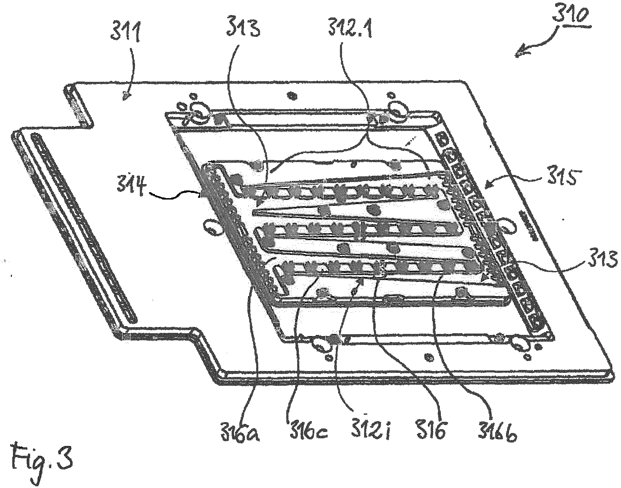

Fig. 3 shows, as an exemplary configuration of an inventive contactor socket, a contactor socket 310 in a perspective view, with removed cover plate. The components and portions of the contactor socket 310, as far as they are the same or functionally corresponding to elements shown in figures 1 and 2, are designated with reference numerals in line with figures 1 and 2.

In a contactor socket body 311 of the contactor socket 310, close to two opposing edges thereof, a plurality of fluid inlet openings 314 and a plurality of fluid outlet openings 315, respectively, is formed. The central portion of the contactor socket 310 comprises three rows of test contact groups, the first of which is designated with numeral 312.1, and a single test contact group in the third row is designated with numeral 312i. The configuration of the test contacts within each test contact group and of the several test contact groups relative to each other corresponds to the DUT contacts of the DUTs which are arranged in a test strip (not shown) placed above the contactor socket and does not constitute an essential aspect of the invention.

Each of the rows of test contact groups is positioned within a row dedicated fluid channel 313, which extends at an acute angle with respect to the orientation of the rows of test contact groups. In a central portion of each of the fluid channels 313 a temperature sensor 316 is provided. As can be seen in the figure, the number of fluid channels (three in this embodiment) is much lower than the number of fluid inlet openings and fluid outlet openings, respectively. Thus, fluid (cooling gas or heating gas) provided by a fluid source flows into each of the fluid channels 313 through at least two fluid inlet openings, and leaves the respective fluid channel through at least two fluid outlet openings.

Each of the fluid channels 313 is sub-divided into two acute-angled triangular channel portions 316a and 316b, by means of a longitudinal wall 316c which accommodates the respective row of test contact groups. The respective walls 316c have fluid passages (not specifically designated) around each of the test contact groups, which connect the first channel portion 316a with the second channel portion 316b and which guide the fluid flow around the test contact groups and between the several contacts of each of the test contact groups. This fluid flow through the several fluid passages is forced by the geometrical shape of the fluid channels insofar, as the first channel portion 316a is closed at its outlet end, whereas the second channel portion 316b is closed at its inlet end.

Fig. 3 does not show throttle means, as shown in Figures 1 and 2. Such throttles can e.g. be configured as strips having plural orifices, the number and shape of which corresponds to the number and shape of the fluid passages around the test contact groups, and which are positioned within each of the fluid channels, shiftable along the extension of the fluid channels, to cover and block smaller or larger cross-sectional portions of the fluid passages between the channel portions. Such throttle can, as mentioned above, be actuated manually or by means of automatic control and actuating means.

The embodiments and aspects of the invention explained above are not determined to limit the scope of the invention, which is exclusively to be determined by the attached claims. Many modifications of the inventive concept are possible within the scope of the claims and, more specifically, arbitrary combinations of the several claim features are considered to be within the scope of the invention.

## Claims

1. Contactor socket of an IC test handler, the contactor socket comprising a contactor socket body having a first and second plane surface, the second plane surface being parallel and opposite to the first plane surface, and
a line or an array of test contacts supported within the contactor socket body, extending between the first and second plane surface and adapted for providing elastic pressure contact with IC device contacts of a plurality of ICs which are positioned on the first plane surface and/or with loadboard contacts of a loadboard positioned on the second plane surface and, thus, an electrical connection between the IC device contacts and loadboard contacts,
wherein the contactor socket body has at least one fluid inlet and at least one fluid outlet and at least one fluid channel connecting the fluid outlet with the fluid inlet, each of the test contacts being positioned in the or at least one fluid channel,
wherein at least one temperature sensor is arranged in the or at least one fluid channel and
the contact socket comprises throttle means arranged at the fluid inlet or fluid outlet or at an inlet side of at least one fluid channel and/or heating and/or cooling means arranged at the or close to the fluid inlet, for heating or cooling a fluid flowing from the fluid inlet through the or the respective fluid channel to the fluid outlet.

2. Contact socket of claim 1, wherein the or at least one temperature sensor is arranged close to a test contact and/or close to the fluid outlet.

3. Contactor socket of claim 1 or 2, wherein the throttle means comprise a plurality of exchangeable inserts to be arranged on the fluid inlet or in the or at least one fluid channel, each of the inserts having a fluid opening the size of which is different from the fluid openings of each of the other inserts of the plurality of inserts.

4. Contactor socket of claim 1 or 2, wherein the throttle means comprise moveable adjustment means for reducing the size of an fluid opening in the fluid inlet or in the or at least one fluid channel.

5. Contactor socket of one of the preceding claims, wherein the heating or cooling means comprises an electroresistive heating element or Peltier cooling element.

6. Contactor socket of one of the preceding claims, wherein the fluid inlet is arranged on a first edge and the fluid outlet is arranged on a second edge, opposite to the first edge, of the contactor socket.

7. Contactor socket of one of the preceding claims, adapted for a test-in-strip handler, comprising a plurality of groups of test contacts, each group of test contacts to provide an electrical connection between a single IC device and the loadboard, wherein the plurality of test contact groups is arranged in a matrix type arrangement of n rows and m columns, and
wherein the contactor socket comprises at least n fluid channels, each of the n rows of the test contact groups being arranged in a row dedicated fluid channel and each of the row dedicated fluid channels comprising at least one temperature sensor.

8. Contactor socket of claim 7, wherein at least one temperature sensor is arranged in a central portion of the respective row dedicated fluid channel.

9. Contactor socket of claim 7 or 8, wherein the direction of extension of the fluid channels is approximately perpendicular or approximately parallel to the direction of extension of the device strip in its test state arranged on the contactor socket.

10. Contactor socket of one of claims 7-9, wherein the number of fluid channels is at least equal to the number of rows of contact element groups.

11. Contactor socket of one of claims 7-10, wherein the direction of extension of the fluid channels is inclined with respect to the direction of extension of the rows of test contact groups at an acute angle, to an extent such that each row of test contact groups is still arranged within a single row dedicated fluid channel, and
wherein between each of the neighbored test contact groups a fluid passage is provided for enabling part of a fluid flowing through the row dedicated fluid channel between the neighbored test contact groups.

12. Contactor socket of one of claims 7-11, wherein between the fluid inlet and the row dedicated fluid channels a plurality of p (p ≥ n) fluid inlet channels and between the row dedicated fluid channels and the fluid outlet a plurality q (q ≥ n) of fluid outlet channels is provided.

13. IC test apparatus for testing ICs, comprising a contactor socket of one of the preceding claims and a temperature determining unit connected to the or each temperature sensor of the contactor socket, for obtaining at least one fluid channel temperature value from the output signal of the or each temperature sensor.

14. IC test apparatus of claim 13, comprising temperature display means for displaying the or each of the fluid channel temperature values provided by the temperature determining unit, and throttle actuating means to enable a test operator to actuate the throttle means of the contactor socket, for adjusting the temperature of at least one of the test contacts.

15. IC test apparatus of claim 13, comprising a temperature control unit for automatically actuating the throttle means in the contactor socket in response to the or each temperature value provided by the temperature determining unit, for controlling the temperature of at least one of the test contacts, wherein at least the temperature control unit and throttle means are in particular arranged within a test handler.

16. IC test apparatus for testing ICs, comprising a contactor socket, the contactor socket comprising
a contactor socket body having a first and second plane surface, the second plane surface being parallel and opposite to the first plane surface, and
a line or an array of test contacts supported within the contactor socket body, extending between the first and second plane surface and adapted for providing elastic pressure contact with IC device contacts of a plurality of ICs which are positioned on the first plane surface and/or with loadboard contacts of a loadboard positioned on the second plane surface and, thus, an electrical connection between the IC device contacts and loadboard contacts,
wherein the contactor socket body has at least one fluid inlet and at least one fluid outlet and at least one fluid channel connecting the fluid outlet with the fluid inlet, each of the test contacts being positioned in the or at least one fluid channel,
wherein at least one temperature sensor is arranged in the or at least one fluid channel; and
a test handler comprising a temperature control unit which at an input is connected to the or each temperature sensor in the contactor socket and is adapted for generating a temperature control signal for temperature control means, in particular fluid control means and/or heating means and/or cooling means, which are arranged outside the contactor socket or are attached to the contactor socket.
